(19) Europäisches Patentamt / European Patent Office / Office européen des brevets

(11) **EP 4 768 648 A1**

(12) **EUROPEAN PATENT APPLICATION**
published in accordance with Art. 153(4) EPC

(43) Date of publication:
**01.07.2026 Bulletin 2026/27**

(21) Application number: **24867106.7**

(22) Date of filing: **30.07.2024**

(51) International Patent Classification (IPC):
**C30B 29/40** (2006.01)    **C30B 29/60** (2006.01)

(52) Cooperative Patent Classification (CPC):
**C30B 1/00; C30B 29/40; C30B 29/60**

(86) International application number:
**PCT/CN2024/108380**

(87) International publication number:
**WO 2025/060689 (27.03.2025 Gazette 2025/13)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **22.09.2023 CN 202311238715**

(71) Applicants:
• **Beijing Tongmei Xtal Technology Co., Ltd.**
  **Beijing 101113 (CN)**
• **Chao Yang Tongmei Xtal Technology Co., Ltd.**
  **Chaoyang, Liaoning 122304 (CN)**

(72) Inventors:
• **XIAO, Yadong**
  **Beijing 101113 (CN)**
• **ZHANG, Shuhui**
  **Beijing 101113 (CN)**
• **SHI, Ning**
  **Beijing 101113 (CN)**

(74) Representative: **Cohausz & Florack**
**Patent- & Rechtsanwälte**
**Partnerschaftsgesellschaft mbB**
**Bleichstraße 14**
**40211 Düsseldorf (DE)**

(54) **INDIUM PHOSPHIDE CRYSTAL CONTAINING DOPED ELEMENT, SINGLE CRYSTAL WAFER, PREPARATION METHOD THEREFOR AND DEVICE**

(57) The present application refers to an indium phosphide crystal containing incorporation element, a single crystal wafer and a preparation method therefor. Specifically, the present application refers to an indium phosphide crystal containing an incorporation element, wherein the incorporation element is incorporated in a growth melt of indium phosphide crystal or incorporated during the synthesis of an indium phosphide polycrystal, wherein the indium phosphide crystal is an S-doped or Sn-doped N-type indium phosphide single crystal or a Zn-doped P-type indium phosphide single crystal; and wherein the incorporation element is one or more elements having a segregation coefficient in indium phosphide of not greater than 0.05; the incorporation element in the indium phosphide crystal is present in an amount of 30 ppb to 30 ppm. The present application further refers to a preparation method of an indium phosphide crystal containing an incorporation element, a preparation method of a single crystal wafer and a device prepared from such indium phosphide crystal. The indium phosphide single crystal obtained thereby has a high yield rate.

FIG. 1

## Description

### Cross-reference to related applications

This application claims priority to Chinese Patent Application No. 202311238715.6 entitled "Indium Phosphide Crystal Containing Incorporation Element, Single Crystal Wafer, Preparation Method Therefor and Device" filed on September 22, 2023, which is hereby incorporated by reference in its entirety.

### Technical field

The present application relates to the field of semiconductor processing and manufacturing, in particular to indium phosphide crystal and preparation method thereof. The present application also relates to an indium phosphide single crystal wafer prepared from the indium phosphide crystal and a preparation method thereof, as well as a device comprising the indium phosphide crystal.

### Background

Indium phosphide (InP), as a semiconductor material of III-V compound, exhibits higher electron mobility than silicon or gallium arsenide, and also has relatively high photoelectric conversion efficiency, relatively strong radiation resistance and relatively high thermal conductivity. These excellent properties make it widely used in various fields such as integrated circuits, high-speed and high-frequency devices, optoelectronic devices, and optical fiber communications.

The manufacturing of an InP single crystal wafer typically includes the steps of growing a single crystal, cutting out a rough wafer from a single crystal rod, edge grinding the rough wafer, lapping, rough polishing, fine polishing, cleaning, drying, and so on. In order to broaden the application range of indium phosphide single crystal wafer and improve its performance, doping is usually used to obtain higher carrier concentration and lower defect density. Doping elements include S, Sn, Zn, Fe, and the like. N-type InP single crystal wafers with high carrier concentration and low defect density are obtained by doping S and Sn; and P-type InP single crystal wafers with high carrier concentration and low defect density are obtained by doping Zn; and semi-insulating InP single crystal wafers are obtained by doping Fe. However, the growth process of the above two semiconducting indium phosphide single crystals (namely P-type InP single crystal and N-type InP single crystal) still inevitably faces the problem of low stacking fault energy of indium phosphide crystals. Due to their low stacking fault energy, twins readily occurs during the growth process, which affects the yield of indium phosphide crystal.

### Summary

The present application is proposed to solve the above problems, by incorporating an incorporation element having a relatively low segregation coefficient into a growth melt of indium phosphide crystals, so as to reduce the formation of twins and thereby improve the yield of indium phosphide single crystals.

Specifically, the first aspect of the present application provides an indium phosphide crystal, wherein the indium phosphide crystal is an S-doped or Sn-doped N-type indium phosphide single crystal or a Zn-doped P-type indium phosphide single crystal; and the indium phosphide crystal further comprises an incorporation element, wherein the incorporation element is one or more elements having a segregation coefficient in indium phosphide of not greater than 0.05, preferably not greater than 0.01, more preferably not greater than 0.008; the incorporation element in the indium phosphide crystal is present in an amount of 30 ppb to 30 ppm.

Another aspect of the present application provides a preparation method of an indium phosphide crystal, the method comprising a step of placing phosphorus, indium phosphide polycrystal, an incorporating agent comprising an incorporation element, and a doping agent comprising an element S or an element Sn or an element Zn, together with a sealant, into a growth vessel, such as a crucible, provided with a seed crystal; wherein the incorporation element is one or more elements having a segregation coefficient in indium phosphide of not greater than 0.05, preferably not greater than 0.01, more preferably not greater than 0.008.

Still another aspect of the present application provides an indium phosphide single crystal wafer, prepared from an N-type indium phosphide single crystal or a P-type indium phosphide single crystal as described above or obtained by the method as described above.

Still another aspect of the present application provides an electronic device or optoelectronic device, prepared from the indium phosphide single crystal wafer as described above or containing a component prepared from the indium phosphide single crystal wafer as described above.

Still another aspect of the present application provides use of an incorporation element for improving the yield of an indium phosphide crystal, wherein the indium phosphide crystal is an S-doped or Sn-doped N-type indium phosphide single crystal or a Zn-doped P-type indium phosphide single crystal; and wherein the incorporation element is one or more elements having a segregation coefficient in indium phosphide of not greater than 0.05, preferably not greater than 0.01, more preferably not greater than 0.008.

The S-doped or Sn-doped N-type indium phosphide single crystal and the Zn-doped P-type indium phosphide single crystal containing the incorporation element obtained in the present application have a high yield and can lead to a single crystal wafer with uniform and stable performance, thus enabling their application in optoelectronic devices such as lasers and photodetectors, electronic devices such as transistors, high-frequency components, and the like.

**Description of the drawings**

FIG. 1 is a cross-sectional view of an embodiment of a crystal growth apparatus containing a sealed vessel for the growth of sulfur-doped and iron-incorporated indium phosphide single crystal.

FIG. 2 is a schematic diagram of a single crystal rod fixing device used in the preparation of a single crystal wafer of the present application.

In order to make the technical objective, technical solutions, and beneficial technical effects of the present application clearer, the following further describes the present application in detail with reference to the specific embodiments. It should be understood that the embodiments and examples described in this specification are merely for the purpose of explaining the present application, and are not intended to limit the application.

For the sake of brevity, only some numerical ranges are explicitly disclosed herein. However, any lower limit may be combined with any upper limit to form a range that is not explicitly described; and any lower limit may be combined with other lower limit to form an unspecified range; and any upper limit may be combined with any other upper limit to form an unspecified range. Further, although not explicitly specified, each point or single value between the endpoints of a range is included in the range. Thus, each point or single value can be combined with any other point or single value or combined with other lower or upper limits to form a range that is not explicitly specified.

Unless stated otherwise, all the embodiments and the preferred embodiments of the present application can be combined with each other to form a new technical solution, and such a technical solution should be considered to be included in the disclosure of the present application.

Unless stated otherwise, all technical features and optional technical features or preferred technical features of the present application can be combined with each other to form a new technical solution, and such a technical solution should be considered to be included in the disclosure of the present application.

**Detailed description**

As previously described, the present application provides an indium phosphide crystal, wherein the indium phosphide crystal is an S-doped or Sn-doped N-type indium phosphide single crystal or a Zn-doped P-type indium phosphide single crystal; and the indium phosphide crystal further comprises an incorporation element, wherein the incorporation element is one or more elements having a segregation coefficient in indium phosphide of not greater than 0.05, preferably not greater than 0.01, more preferably not greater than 0.008; the incorporation element in the indium phosphide crystal is present in an amount of 30 ppb to 30 ppm.

Herein, the term "doping element" is used to mean an S, Sn or Zn element introduced to achieve the P-type or N-type of indium phosphide crystal; The term "incorporation element" or "incorporated element" is used to mean additional elements other than S, Sn or Zn, such as Fe, which are additionally added during the preparation of the indium phosphide crystal.

Without being bound by any theory, the inventors have found that incorporating an element having a relatively low segregation coefficient in indium phosphide into a growth melt of indium phosphide crystal (including S-doped or Sn-doped N-type indium phosphide single crystal or Zn-doped P-type indium phosphide single crystal) can effectively inhibit the generation of twins and thereby improve the yield of indium phosphide single crystal, because such an element can effectively change the solid-liquid interface condition and inhibit the growth of indium phosphide single crystal in other crystal orientations, and thus effectively suppress the formation of twins. The inventors believe that the main reason is that such an element having a relatively low segregation coefficient in indium phosphide, such as about 0.0016 for iron, is effective at the growth interface, although high levels in the melt do not cause high levels in the grown crystal; and S or Sn or Zn atoms as an effective doping element have sufficiently high segregation coefficients in indium phosphide, such as about 0.68 for sulfur, so that S or Sn or Zn atoms can effectively enter the grown crystal to achieve N-type or P-type doping. In addition, the introduction of such an element further changes the viscosity of the melt during crystal growth, increases the stacking fault energy, and thus effectively inhibits the appearance of twins. The inventors have also found that incorporating an incorporation elements such as Fe into N-type indium phosphide single crystal or P-type indium phosphide single crystal at the concentration described herein does not adversely affect the electrical or optoelectronic properties of the N-type indium phosphide single crystal or the P-type indium phosphide single crystal; and the resulting N-type indium phosphide single crystal or the P-type indium phosphide single crystal containing the incorporation element still satisfies the requirements of electronic devices or optoelectronic devices.

As used herein, the term "segregation coefficient", also known as the effective partition coefficient, refers to the different solubility of impurities in different phases at the solid-liquid interface, resulting in the different concentrations of impurities distributed in materials on both sides of the interface. The segregation coefficient is expressed by K, K = (solubility of impurity in solid phase)/(solubility of impurity in liquid phase) ($K = C_s/C_1$). The segregation coefficients of elements can be determined by those skilled in the art by using methods known in the art, for example, according to the method described in the article by Fang Dunfu et al., titled "The Growth and Characterics of S-doped Low Dislocation InP Single Crystals" (Journal of Applied Sciences, Vol. 1, Issue 3, Jul. 1983).

It should be noted that the N-type or P-type indium phosphide crystal containing the incorporation element (e.g. Fe) in the present application is distinct from the semi-insulating type indium phosphide crystal doped with Fe known in the prior art. In the prior art, Fe is doped as a doping element into an indium phosphide crystal to form an insulating or semi-insulating indium phosphide crystal. In contrast, the indium phosphide crystal according to the present application refers to an N-type indium phosphide single crystal or a P-type indium phosphide single crystal. It is unexpected that the final electrical properties of the crystal obtained by adding Fe element, which is usually doped for preparing insulating indium phosphide crystals, to the N-type indium phosphide single crystal or the P-type indium phosphide single crystal in a prescribed amount, still conform to the semiconductor properties of the N-type indium phosphide single crystal or the P-type indium phosphide single crystal.

In some embodiments of the present application, the incorporation element is incorporated in a growth melt of indium phosphide crystal or incorporated during the synthesis of an indium phosphide polycrystal.

In some embodiments of the present application, the incorporation element is one or more elements having a segregation coefficient in indium phosphide of not greater than 0.05, preferably not greater than 0.01, more preferably not greater than 0.08, such as not greater than 0.007, 0.006, 0.005, 0.004, 0.003 or 0.002. The incorporation element in the indium phosphide crystal may be present in an amount of 30 ppb to 30 ppm. For example, the incorporation amount of the incorporation element may be 35 ppb, 40 ppb, 50 ppb, 55 ppb, 60 ppb, 65 ppb, 70 ppb, 75 ppb, 80 ppb, 85 ppb, 90 ppb, 95 ppb, 100 ppb, 105 ppb, 110 ppb, 115 ppb, 120 ppb, 130 ppb, 135 ppb, 140 ppb, 145 ppb, 150 ppb, and the like. The incorporation amount of the incorporation element may be 30 ppm, 20 ppm, 15 ppm, 10 ppm, 5 ppm, 3 ppm, 2 ppm, 1 ppm, 0.5 ppm, 0.4 ppm, 0.3 ppm, or the like, or may be within an arbitrary range formed with any of the above amounts or any of the amounts disclosed in the examples of the present application as end values.

In the present application, the amount of the doping element (such as sulfur and tin) and incorporation element (such as iron) in indium phosphide crystals can be determined by Glow Discharge Mass Spectrometry (GDMS) or Secondary Ion Mass Spectrometry (SIMS). In a glow discharge ion source, a potential difference is applied between the cathode (the sample being analyzed) and the anode, and a plasma is sustained by introducing an inert gas (typically argon). The inert gas ions and fast neutral species formed in the plasma are attracted to the sample surface, and their impact causes sputtering of the sample surface to produce neutral species. These neutral particles diffuse into the plasma and are subsequently ionized in the equipotential region of the plasma, and can then be extracted into mass spectrometry for quantitative analysis. For example, glow discharge mass spectrometry can be carried out in accordance with the current testing standard-"DB35/T 1146-2011 Impurity Content in Silicon Materials Measured by Glow discharge Mass Spectrometry".

It should be noted that the indium phosphide crystals provided herein are typically in the form of single crystal rods. For indium phosphide crystal in the form of single crystal rod, it has been found that the atomic content of an incorporation element varies at different cross sections along the growth direction of single crystal rod, that is, the distribution of an incorporation element in indium phosphide crystal is not uniform, which is mainly related to the segregation coefficient K of the incorporation element in indium phosphide.

The distribution relationship between the position and the content of an incorporation element in the crystal rod is given in the following formula (according to Pfann, W.G., "Zone Melting"),

$$C_x = K \cdot C_0 (1-X)^{(K-1)}$$

wherein $C_x$ is the solubility of the incorporation element in the solid phase at different cross sections; X is the ratio of the length of the crystallized portion to the total length of the crystal; $C_0$ is the solubility of the incorporation element in the liquid phase in the molten state before crystallization.

That is, the distribution of an incorporation element (K < 1) in indium phosphide crystal is not uniform; Its content gradually increases nonlinearly from the head where the crystal rod begins to the tail of the crystal. Therefore, in the case that the indium phosphide crystal is in the form of a single crystal rod or that the distribution of the incorporation element in the indium phosphide crystal is not uniform, the range specified in the present application for the content of the incorporation element in the indium phosphide crystal should be understood to mean that the content of the incorporation element at any position of the finished single crystal rod (but excluding the tip-most and tail-most portions of the single crystal rod that should be discarded during processing) falls within the specified range.

The indium phosphide crystals provided herein may also be in the form of a single crystal wafer. The single crystal wafer can be obtained, for example, by cutting an indium phosphide single crystal rod. When the indium phosphide crystal is in the form of a single crystal wafer, the types of the incorporation element in the indium phosphide crystal and the content of the incorporation element in the crystal are also as described above.

In some preferred embodiments of the present application, the incorporation element is selected from elements having a low segregation coefficient and not affecting the main properties of the original N-type or P-type indium phosphide crystal and the epitaxial use of the single crystal wafer. The incorporation element is preferably element iron.

In some preferred embodiments of the present application, the incorporation element incorporated into the indium phosphide crystal comprises iron, preferably is iron.

In some preferred embodiments of the present application, the content (or "amount") of the incorporation element is from 30 ppb to 30 ppm, preferably from 100 ppb to 15 ppm, more preferably from 150 ppb to 10 ppm.

In some preferred embodiments of the present application, the indium phosphide crystal is an S-doped or Sn-doped N-type indium phosphide single crystal; wherein the carrier concentration of the N-type indium phosphide single crystal is $1\times10^{17}$ cm$^{-3}$ to $5\times10^{19}$ cm$^{-3}$, for example, $1\times10^{18}$ cm$^{-3}$ to $1\times10^{19}$ cm$^{-3}$, preferably $1\times10^{18}$ cm$^{-3}$ to $8\times10^{18}$ cm$^{-3}$, or I$^{X}$ lo$^{ll}$ cm$^{-3}$ to $9\times10^{17}$ cm$^{-3}$, preferably $3\times10^{17}$ cm$^{-3}$ to $5\times10^{17}$ cm$^{-3}$.

In some preferred embodiments of the present application, the indium phosphide crystal is an S-doped or Sn-doped N-type indium phosphide single crystal having a carrier concentration of $1\times10^{18}$ cm$^{-3}$ to $1\times10^{19}$ cm$^{-3}$, preferably $1\times10^{18}$ cm$^{-3}$ to $8\times10^{18}$ cm$^{-3}$. In still some preferred embodiments of the present application, the indium phosphide crystal is an S-doped or Sn-doped N-type indium phosphide single crystal having a carrier concentration of $1\times10^{17}$ cm$^{-3}$ to $9\times10^{17}$ cm$^{-3}$, preferably $3\times10^{17}$ cm$^{-3}$ to $5\times10^{17}$ cm$^{-3}$.

In some preferred embodiments of the present application, the indium phosphide crystal is a Zn-doped P-type indium phosphide single crystal having a carrier concentration of $1\times10^{17}$ cm$^{-3}$ to $5\times10^{19}$ cm$^{-3}$, preferably $1\times10^{18}$ cm$^{-3}$ to $1\times10^{19}$ cm$^{-3}$.

In this application, the carrier concentration refers to the number of carriers per unit volume (cm$^3$). It equals the concentration of ionized impurities in the absence of compensation at room temperature. The carrier concentration can be measured by using methods well known in the art, for example, by means of a Hall instrument.

The indium phosphide single crystal of the present application has low dislocation density and uniform dislocation distribution. In some preferred embodiments of the present application, the average dislocation density of the indium phosphide crystal may be 800/cm$^2$ or lower, or 500/cm$^2$ or lower, or 100/cm$^2$ or lower, even 50/cm$^2$ or lower.

In the present application, the dislocation density of the indium phosphide single crystal is determined by the method described in GB/T20230-2022 "Indium Phosphide Single Crystal".

Still another aspect of the present application provides a preparation method of an indium phosphide crystal, the method comprising a step of placing phosphorus, indium phosphide polycrystal, an incorporating agent comprising an incorporation element, and a doping agent comprising an element sulfur or an element tin or an element zinc, together with a sealant, into a growth vessel (such as a crucible) provided with a seed crystal; wherein the incorporation element has a segregation coefficient in indium phosphide of not greater than 0.05, preferably not greater than 0.01 preferably not greater than 0.008.

Herein, the term "dopant" or "doping agent" is used to mean a substance used in the preparation of the indium phosphide crystal to provide an element such as S, Sn, or Zn required to achieve the P-type or N-type of the indium phosphide crystal. The term "incorporating agent" is used to mean a substance used to provide an incorporation element (e.g. an element having a fractionation coefficient of not greater than 0.05, such as Fe) during the preparation of indium phosphide crystals.

In the present application, the apparatus used in the preparation method of indium phosphide crystal (for example, a growth vessel, a melting furnace, etc.) may be conventional apparatus known or commonly used in the art for preparing an N-type indium phosphide single crystal or a P-type indium phosphide single crystal.

In the present application, the raw materials including phosphorus, indium phosphide polycrystal, doping element and sealant used in the preparation method of indium phosphide crystal may all be conventional raw materials known in the art for preparing N-type or P-type indium phosphide single crystals, which may be prepared in-house or obtained commercially. These raw materials are generally of high purity, preferably 99.00% or higher, for example 99.99% or higher.

In the present application, as a raw material in the preparation method of indium phosphide crystal, the incorporating agent comprising an incorporation element is selected from the group consisting of a simple substance of the element, a sulfide of the element, a phosphide of the element, an alloy of the element with indium, or a mixture thereof. The incorporating agent used is preferably of high purity, preferably 99.00% or higher, for example 99.99% or higher.

In some preferred embodiments of the present application, the incorporation element is preferably iron, and the incorporating agent comprising the incorporation element is selected from the group consisting of iron, iron sulfide ($Fe_2S_3$), ferrous sulfide (FeS), ferrous disulfide ($FeS_2$), a phosphide of iron, iron indium alloy, or any mixture thereof. The iron used is high-purity iron, preferably with a purity of 99.00% or higher, for example 99.99% or higher.

In the present application, the operation of placing phosphorus, an indium phosphide polycrystal, an incorporating agent, a doping agent and a sealant into a growth vessel may be implemented in a variety of ways. For example, phosphorus, an indium phosphide polycrystal, an incorporating agent, a doping agent and a sealant may be added to the growth vessel simultaneously or sequentially; or an incorporating agent may be pre-mixed into the indium phosphide polycrystal (or the incorporating agent may be introduced during the preparation of the indium phosphide polycrystal to form an indium phosphide polycrystal containing the incorporation element) before being added to the growth vessel; or a doping agent may be pre-mixed into the indium phosphide polycrystal (or the doping agent may be introduced during the preparation of the indium phosphide polycrystal to form an indium phosphide polycrystal containing the doping element) before being added to the growth vessel; or even both an incorporating agent and a doping agent may be pre-mixed into the indium phosphide polycrystal (or both the incorporating agent and the doping agent may be introduced during the preparation of the indium phosphide polycrystal to form an indium phosphide polycrystal containing the incorporation element and the doping element) before being added to the growth vessel. All of these implementations may be used to prepare the indium phosphide crystals of the present application. On this basis, other equivalent implementations can also be conceived by those skilled in the art, and all of the above implementations and other equivalent implementations are considered to be within the scope of the disclosure of this application.

In some preferred embodiments of the present application, the amount of the incorporating agent comprising an incorporation element is selected so that the amount of the incorporation element in the resulting single crystal rod is from 30 ppb to 30 ppm, preferably from 50 ppb to 20 ppm, more preferably from 100 ppb to 15 ppm; and the amount of the doping agent comprising an element S or an element Sn or an element Zn is selected so that the carrier concentration of the resulting indium phosphide single crystal rod within effective length is $1\times10^{17}$ cm$^{-3}$ to $5\times10^{19}$ cm$^{-3}$, preferably $1\times10^{18}$ cm$^{-3}$ to $1\times10^{19}$ cm$^{-3}$.

In some embodiments, the preparation method of an indium phosphide crystal further comprises:

> a step of placing said vessel in a crystal growth furnace and heating to a temperature of the melting point of indium phosphide or higher; and
> a step of stepwise cooling the melt in the vessel to obtain an N-type or P-type indium phosphide single crystal.

In some preferred embodiments, the step of placing said vessel in a crystal growth furnace and heating to a temperature of the melting point of indium phosphide or higher comprises the steps of: placing said vessel in a crystal growth furnace and heating using a multi-temperature zone system, preferably establishing a temperature gradient of 0.1-10.0 °C/cm in the single crystal rod growth zone, so that the temperature is increased and maintained at the melting point of indium phosphide or higher; then gradually cooling the obtained melt in the vessel to obtain S-doped or Sn-doped N-type indium phosphide single crystal or Zn-doped P-type indium phosphide single crystal comprising an incorporation element.

The inventors have found that incorporation of the incorporation element into an indium phosphide crystal growth melt can reduce the probability of generation of twin defects, thereby increasing the yield (yield rate), and that the performance of the crystal incorporated with the incorporation element is substantially the same as that of S-doped or Sn-doped N-type indium phosphide single crystal or Zn-doped P-type indium phosphide single crystal not incorporated with the incorporation element, and that the presence of the incorporation element in the crystal is merely at a trace level, while the dislocation density of the obtained single crystal is not increased.

The amounts of the raw materials including phosphorus, indium phosphide polycrystal, doping element and sealant used in the preparation method of indium phosphide crystal of the present application may be determined by a person skilled in the art according to actual needs. However, for the amount of the used incorporation element can generally be determined as follows: the total mass of the doping element in the doping agent and the incorporation element in the incorporating agent is from 0.001% to 1% (10 ppm to 10000 ppm), for example, 15 ppm, 20 ppm, 25 ppm, 50 ppm, 75 ppm, 100 ppm, 125 ppm, 150 ppm, 200 ppm, 250 ppm, 500 ppm, 700 ppm, 1000 ppm, 2000 ppm, 3000 ppm, 4000 ppm, 5000 ppm, 6000 ppm, 7000 ppm, 8000 ppm, 9000 ppm, or within an interval (or a range) composed of any of the above amounts as an end value, relative to the total weight of the indium phosphide polycrystal; and wherein the mass ratio of the doping element in the doping agent to the incorporation element in the incorporating agent in the solid state is from 1 : 0.1 to 1 : 10, preferably from 1 : 0.5 to 1 : 6, more preferably from 1 : 0.7 to 1 : 5. In the preparation method of an S-doped N-type indium phosphide single crystal, the total mass of the sulfur in the doping agent comprising the element S and the incorporation element in the incorporating agent comprising said incorporation element is from 0.001% to 1% (10 ppm to 10000 ppm), relative to the total weight of the indium phosphide polycrystal; wherein the mass ratio of the element S in the doping agent to the incorporation element in the incorporating agent in the solid state is from 1 : 0.1 to 1 : 10, preferably from 1 : 0.5 to 1 : 6, more preferably from 1 : 0.7 to 1 : 5 on an element mass.

In the preparation method of an Sn-doped N-type indium phosphide single crystal, the total mass of the tin in the doping agent comprising the element Sn and the incorporation element in the incorporating agent comprising said incorporation element is from 0.001% to 1% (10 ppm to 10000 ppm), relative to the total weight of the indium phosphide polycrystal; wherein the mass ratio of the element Sn in the doping agent to the incorporation element in the incorporating agent in the solid state is from 1 : 0.01 to 1 : 0.5, preferably from 1 : 0.05 to 1 : 0.3, more preferably from 1 : 0.08 to 1 : 0.15.

In the Zn-doped P-type indium phosphide single crystal, the total mass of the zinc in the doping agent comprising the element Zn and the incorporation element in the incorporating agent comprising said incorporation element is from 0.001% to 1% (10 ppm to 10000 ppm), relative to the total weight of the indium phosphide polycrystal; wherein the mass ratio of the element Zn in the doping agent to the incorporation element in the incorporating agent in the solid state is from 1 : 0.1 to 1 : 10, preferably from 1 : 0.5 to 1: 6, more preferably from 1 : 0.7 to 1 : 5 on an element mass.

In some preferred embodiments of the present application, the incorporation element is selected from elements having a low segregation coefficient and not affecting the main properties of indium phosphide crystal and the epitaxial use of the single crystal wafer.

In some preferred embodiments of the present application, the incorporation element is preferably iron element.

In some preferred embodiments of the present application, the incorporating agent comprising an incorporation element is selected from the group consisting of a simple substance of the element, a sulfide of the element, a phosphide of the element, an alloy of the element with indium, or a mixture thereof. When said incorporation element is iron, the incorporating agent comprising iron element is selected from the group consisting of iron, iron sulfide ($Fe_2S_3$), ferrous sulfide (FeS), ferrous disulfide ($FeS_2$), a phosphide of iron, iron indium alloy, or any mixture thereof. The incorporating agent used is preferably of high purity, preferably has a purity of 99.00% or higher, for example 99.99% or higher.

In some preferred embodiments of the present application, for the S-doped N-type indium phosphide single crystal, the doping agent comprising the element S is selected from the group consisting of sulfur, sulfides of indium, or mixtures thereof; the incorporating agent comprising an incorporation element is selected from the group consisting of a simple substance of the element, a sulfide of the element, a phosphide of the element, an alloy of the element with indium, or a mixture thereof.

In some preferred embodiments of the present application, for the S-doped N-type indium phosphide single crystal, the doping agent comprising the element S is selected from the group consisting of sulfur, sulfides of indium ($In_2S_3$ and/or $In_2S$), or mixtures thereof; Said incorporation element is preferably iron, and the incorporating agent comprising iron element is selected from the group consisting of iron, iron sulfide ($Fe_2S_3$), ferrous sulfide (FeS), ferrous disulfide ($FeS_2$), a phosphide of iron, iron indium alloy, or any mixture thereof. The iron used is high-purity iron, preferably with a purity of 99.00% or higher, for example 99.99%. Incorporating iron into S-doped indium phosphide single crystal can effectively improve the crystal formation rate of single crystal during crystal growth.

In some preferred embodiments of the present application, for the S-doped N-type indium phosphide single crystal, the used doping agent comprising the element S is sulfur, indium sulfide, or a mixture of indium sulfide and sulfur.

In some preferred embodiments of the present application, the total mass of sulfur in the doping agent containing the element S and the incorporation element in the incorporating agent comprising said incorporation element are from 0.001% to 1% (10 ppm to 10000 ppm), relative to the total weight of the indium phosphide polycrystals; preferably, wherein the mass ratio of the element S in the doping agent to the incorporation element in the incorporating agent in the solid state is from 1 : 0.1 to 1 : 10, preferably from 1 : 0.5 to 1 : 6, more preferably from 1 : 0.7 to 1 : 5 on an element mass.

In some preferred embodiments of the present application, for the Sn-doped N-type indium phosphide single crystal, the doping agent comprising the element Sn is selected from the group consisting of tin, a phosphide of tin, an alloy of tin and indium, or mixtures thereof; the incorporating agent comprising an incorporation element/impurity element is selected from the group consisting of a simple substance of the element, a phosphide of the element, an alloy of the element with indium, or a mixture thereof.

In some preferred embodiments of the present application, the total mass of tin in the doping agent containing the element Sn (tin) and the incorporation element in the incorporating agent comprising said incorporation element are from 0.001% to 1% (10 ppm to 10000 ppm), relative to the total weight of the indium phosphide polycrystals; preferably, wherein the mass ratio of the element Sn in the doping agent to the incorporation element in the incorporating agent in the solid state is from 1 : 0.01 to 1 : 0.5, preferably from 1 : 0.05 to 1 : 0.3, more preferably from 1 : 0.08 to 1 : 0.15 on an element mass.

In some preferred embodiments of the present application, for the Zn-doped P-type indium phosphide single crystal, the doping agent comprising the element Zn is selected from the group consisting of zinc, a phosphide of zinc, an alloy of zinc and indium, or mixtures thereof; the incorporating agent comprising an incorporation element is selected from the group consisting of a simple substance of the element, a phosphide of the element, an alloy of the element with indium, or a mixture thereof.

In some preferred embodiments of the present application, the total mass of zinc in the doping agent containing the element Zn (zinc) and the incorporation element in the incorporating agent comprising said incorporation element are from 0.001% to 1% (10 ppm to 10000 ppm), relative to the total weight of the indium phosphide polycrystals; preferably, wherein the mass ratio of the element Zn in the doping agent to the incorporation element in the incorporating agent in the solid state is from 1 : 0.1 to 1 : 10, preferably from 1 : 0.5 to 1 : 6, more preferably from 1 : 0.7 to 1 : 5 on an element mass.

In some preferred embodiments of the present application, the method of preparing crystals is selected from a vertical Bridgman method (VB), a vertical gradient freeze method (VGF), a vapor-pressure-controlled Czochralski method (VCZ), or a vertical crucible growth method.

In some preferred embodiments of the present application, the method of preparing the crystals is vertical gradient freeze method (VGF), in which the crucible may be moved in a temperature field or the crucible may remain stationary with changes in the temperature field.

In some preferred embodiments of the present application, vertical gradient freeze method (VGF) is employed, comprising the steps of:

1) placing phosphorus, indium phosphide polycrystal, a doping agent comprising an element S or an element Sn or an element Zn and an incorporating agent comprising an incorporation element, together with boron oxide as a sealant, into a crucible provided with a seed crystal;
2) placing the crucible of step 1) in a growth tube (preferably a quartz tube, but other types of growth tubes may also be used) and sealing the growth tube under vacuum;
3) placing the sealed growth tube with crucible of step 2) in a crystal growth furnace (preferably heating using a multi-temperature zone system, more preferably establishing a temperature gradient of 0.1-10.0 °C/cm in the single crystal rod growth zone), so that the temperature is increased and maintained at the melting point of indium phosphide or higher;
4) gradually cooling the obtained melt in the crucible of step 3) to obtain S-doped or Sn-doped N-type indium phosphide single crystal or Zn-doped P-type indium phosphide single crystal comprising an incorporation element.

By taking the preparation of S-doped N-type indium phosphide single crystal doped with iron element as an example, the preparation method is further described below:

In step 1), the amount of the doping agent comprising an element S (especially the mixture of indium sulfide and sulfur) and the amount of the incorporating agent comprising iron are selected so that the carrier concentration of the resulting indium phosphide single crystal rod within effective length is $1\times10^{17}$ cm$^{-3}$ to $5\times10^{19}$ cm$^{-3}$, preferably $1\times10^{18}$ cm$^{-3}$ to $1\times10^{19}$ cm$^{-3}$, and the amount of iron is from 30 ppb to 30 ppm.

Preferably, the incorporating agent comprising iron element used in step 1) is high purity iron, preferably with a purity of 99.00% or higher, for example 99.99%; the phosphorus is high purity 4N, preferably 6N or even higher purity red phosphorus; sulfur and its compounds are of high purity 4N, preferably 6N or even higher purity.

Preferably, in step 3), a temperature gradient of 0.1 °C/cm to 10.0 °C/cm is established in the single crystal rod growth zone during the crystalline growth of the melt into the indium phosphide single crystal rod when the melt is brought into contact with the seed crystal.

The indium sulfide used in the method of preparing a single crystal rod of the present application may be synthesized by known methods.

The growth vessel for the indium phosphide single crystal rod of the present application may be prepared with a suitable crucible material, such as a pyrolytic boron nitride (PBN) crucible. The vessel or crucible for single crystal growth comprises a cylindrical main body having a diameter slightly larger than the diameter of the indium phosphide single crystal rod to be prepared (on the condition that the indium phosphide single crystal rod can be completely accommodated without making contact with the wall of the cylindrical main body), a bottom seed crystal (also called crystal seed) tank with a small diameter, and a conical transition zone between the bottom seed crystal tank and the cylindrical main body. The seed crystal tank is used for accommodating cylindrical seed crystals for the preparation of indium phosphide single crystals.

The crystal orientation of the upper end face of the seed crystal is the surface crystal orientation of the indium phosphide single crystal substrate desired to be obtained, for example (100) or a surface crystal orientation deflected at an angle to the adjacent crystal orientation axis with respect to the (100) crystal orientation.

In the present application, a sulfide of indium having a lower vapor pressure (selected from $In_2S_3$, $In_2S$ or a mixture thereof) or a mixture of indium sulfide and sulfur is used as a sulfur source; in the present application, high-purity iron, such as iron wire with 99.99% purity, is used as an iron source, and the effective introduction of sulfur and iron elements further greatly improves the yield of single crystal.

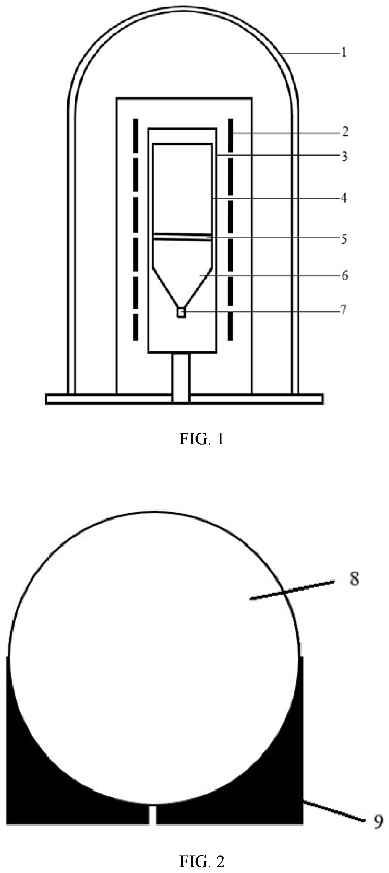

As shown in FIG. 1, a suitable sealant 5 (such as boron oxide) is placed in a crucible 4 together with raw materials 6, wherein the raw materials 6 comprise phosphorus, indium phosphide polycrystal, and a doping agent comprising sulfur and an incorporating agent comprising iron. The sealant can isolate the inner wall of the crucible from the surface of the melt or the solid single crystal rod in the process of single crystal growth, thereby reducing the adhesion between the surface of the grown single crystal rod and the inner wall of the crucible, and making it easier to obtain a complete indium phosphide single crystal rod. The amount of the sealant used is conventional in the art.

According to the above preparation method of the present application, an indium phosphide crystal according to the first aspect of the present application can be provided, wherein the indium phosphide crystal is an S-doped or Sn-doped N-type indium phosphide single crystal or a Zn-doped P-type indium phosphide single crystal; and the indium phosphide crystal further comprises an incorporation element, wherein the incorporation element is one or more elements having a segregation coefficient in indium phosphide of not greater than 0.05, preferably not greater than 0.01, more preferably not greater than 0.008; the incorporation element in the indium phosphide crystal is present in an amount of 30 ppb to 30 ppm.

Another aspect of the present application provides use of an incorporation element for improving the yield of an indium phosphide crystal, wherein the indium phosphide crystal is an S-doped or Sn-doped N-type indium phosphide single crystal or a Zn-doped P-type indium phosphide single crystal; and wherein the incorporation element is one or more elements; wherein the incorporation element has a segregation coefficient in indium phosphide of not greater than 0.05, preferably not greater than 0.01 preferably not greater than 0.008.

The present application provides an indium phosphide single crystal wafer comprising an incorporation element, prepared from an N-type indium phosphide single crystal or a P-type indium phosphide single crystal as described above or obtained by the method as described above. wherein the S-doped or Sn-doped N-type indium phosphide single crystal wafer has a carrier concentration of $1\times10^{17}$ cm$^{-3}$ to $5\times10^{19}$ cm$^{-3}$, preferably $1\times10^{18}$ cm$^{-3}$ to $1\times10^{19}$ cm$^{-3}$, more preferably $1\times10^{18}$ cm$^{-3}$ to $8\times10^{18}$ cm$^{-3}$; the Zn-doped P-type indium phosphide single crystal wafer has a carrier concentration of $1\times10^{17}$ cm$^{-3}$ to $5\times10^{19}$ cm$^{-3}$, preferably $1\times10^{18}$ cm$^{-3}$ to $1\times10^{19}$ cm$^{-3}$. The atomic content of the incorporated element is between 30 ppb and 30 ppm.

The indium phosphide single crystal wafer may be prepared using conventional methods in this field from the N-type indium phosphide single crystal or a P-type indium phosphide single crystal as described above, or prepared from the N-type indium phosphide single crystal or a P-type indium phosphide single crystal obtained by the method as described above. The indium phosphide single crystal wafer comprising the incorporation element can be prepared by cutting the indium phosphide single crystal rod containing the incorporation element of the present application. Industrial preparation methods typically include the steps of cutting out a rough wafer from a single crystal rod, edge grinding the rough wafer, lapping, rough polishing, fine polishing, cleaning, and drying, and so on.

In the present application, the diameter of a single crystal wafer should be understood as follows: When a single crystal wafer is circular, it refers to the diameter of the circle; When a single crystal wafer has other shapes (such as irregular circles, squares, rectangles, etc.), it refers to the diameter of a circle formed by drawing a circle with the center of the single crystal wafer as the center of the circle so that the circle includes all parts of the single crystal wafer.

In the present application, the term "effective length" means the actual length that a single crystal rod can be used for cutting into single crystal wafers.

The indium phosphide single crystal wafer of the present application has a thickness of from 200 $\mu$m to 2000 $\mu$m, preferably from 300 $\mu$m to 1200 $\mu$m.

The indium phosphide single crystal wafer of the present application is made by cutting an indium phosphide single crystal rod, which is a single crystal rod with a circular transverse cross section (referred to as a circular single crystal rod for short), and the diameter of the circular cross section is usually not more than 12 inches, preferably 1 inch to 8 inches. Apparently, the indium phosphide single crystal rod may also be a single crystal rod having another shape in the transverse cross section, for example, an indium phosphide single crystal rod having a square (square or rectangle) in the transverse cross section obtained by processing a circular single crystal rod, and in this case, the cut crystal wafer is a non-circular indium phosphide single crystal wafer.

The indium phosphide single crystal wafer of the present application is preferably cut from the single crystal rod produced by the preparation method of the indium phosphide single crystal rod as described herein. The processing of the indium phosphide single crystal wafer of the present application is exactly the same as the processing of a conventional S-doped single crystal. A specific example of the processing method of the indium phosphide single crystal wafer of the present application may be referred to Chinese Patent Publication CN 116043318 A, the content of which is incorporated herein by reference.

The indium phosphide single crystal wafer as described herein may be used for epitaxial growth thereon or further fabrication or processing into devices including, but not limited to, optoelectronic devices such as lasers, detectors, light emitting diodes, etc., or electronic devices such as HBT, MESFET, PHEMT, etc.

Still another aspect of the present application provides an electronic device or optoelectronic device, prepared from the indium phosphide single crystal wafer as described above or containing a component prepared from the indium phosphide single crystal wafer as described above. The optoelectronic device includes, for example, a laser, a detector, a light emitting diode, and the like, and the electronic device includes, for example, an HBT, a MESFET, a PHEMT, and the like.

The present application may be illustrated by the following embodiments:

Embodiment 1. An indium phosphide crystal, wherein the indium phosphide crystal is an S-doped or Sn-doped N-type indium phosphide single crystal or a Zn-doped P-type indium phosphide single crystal; and
the indium phosphide crystal further comprises an incorporation element, wherein the incorporation element is one or more elements having a segregation coefficient in indium phosphide of not greater than 0.05, preferably not greater than 0.01, more preferably not greater than 0.008; the incorporation element in the indium phosphide crystal is present in an amount of 30 ppb to 30 ppm.

Embodiment 2. The indium phosphide crystal according to Embodiment 1, wherein the amount of the incorporation element is from 30 ppb to 20 ppm, preferably from 100 ppb to 15 ppm, more preferably from 150 ppb to 10 ppm.

Embodiment 3. The indium phosphide crystal according to Embodiment 1 or 2, wherein the incorporation element comprises iron.

Embodiment 4. The indium phosphide crystal according to any one of Embodiments 1 to 3, wherein the incorporation element is element iron.

Embodiment 5. The indium phosphide crystal according to any one of Embodiments 1 to 4, wherein the indium phosphide crystal is an S-doped or Sn-doped N-type indium phosphide single crystal, and the carrier concentration of the N-type indium phosphide single crystal is $1 \times 10^{17}$ cm$^{-3}$ to $5 \times 10^{19}$ cm$^{-3}$, for example, $1 \times 10^{18}$ cm$^{-3}$ to $1 \times 10^{19}$ cm$^{-3}$, preferably $1 \times 10^{18}$ cm$^{-3}$ to $8 \times 10^{18}$ cm$^{-3}$, or $1 \times 10^{17}$ cm$^{-3}$ to $9 \times 10^{17}$ cm$^{-3}$, preferably $3 \times 10^{17}$ cm$^{-3}$ to $5 \times 10^{17}$ cm$^{-3}$.

Embodiment 6. The indium phosphide crystal according to any one of Embodiments 1 to 4, wherein the indium phosphide crystal is a Zn-doped P-type indium phosphide single crystal having a carrier concentration of $1 \times 10^{17}$ cm$^{-3}$ to $5 \times 10^{19}$ cm$^{-3}$, preferably $1 \times 10^{18}$ cm$^{-3}$ to $1 \times 10^{19}$ cm$^{-3}$.

Embodiment 7. The indium phosphide crystal according to any one of Embodiments 1 to 6, wherein the indium phosphide crystal is in the form of an indium phosphide single crystal rod.

Embodiment 8. A preparation method of an N-type or P-type indium phosphide single crystal, the method comprising a step of placing phosphorus, indium phosphide polycrystal, an incorporating agent comprising an incorporation element, and a doping agent comprising an element S or an element Sn or an element Zn, together with a sealant, into a growth vessel (such as a crucible) provided with a seed crystal; wherein the incorporation element has a segregation coefficient in indium phosphide of not greater than 0.05, preferably not greater than 0.01 preferably not greater than 0.008.

Embodiment 9. The method according to Embodiment 8, further comprising:

a step of placing said vessel in a crystal growth furnace and heating to a temperature of the melting point of indium phosphide or higher; and
a step of stepwise cooling the melt in the vessel to obtain the N-type or P-type indium phosphide single crystal.

Embodiment 10. The method according to Embodiment 9, wherein the step of placing said vessel in a crystal growth furnace and heating to a temperature of the melting point of indium phosphide or higher comprises: placing said vessel in a crystal growth furnace and heating using a multi-temperature zone system, preferably establishing a temperature gradient of 0.1-10.0 °C/cm in the single crystal rod growth zone, so that the temperature is increased and maintained at the melting point of indium phosphide or higher.

Embodiment 11. The method according to any one of Embodiments 8 to 10, wherein the incorporation element comprises iron, more preferably is element iron.

Embodiment 12. The method according to any one of Embodiments 8 to 11, wherein the incorporation element in the obtained indium phosphide crystal is present in an amount of 30 ppb to 30 ppm.

Embodiment 13. The method according to any one of Embodiments 8 to 12, wherein a melt comprising the incorporation element has a viscosity different from that of the melt not comprising the incorporation element, and the incorporation element does not affect the main properties of the crystal and epitaxial use of single crystal wafer.

Embodiment 14. The method according to any one of Embodiments 8 to 13, wherein

when a doping agent comprising element S is used for preparing S-doped N-type indium phosphide single crystal, the doping agent comprising element S is selected from the group consisting of sulfur, sulfides of indium, or mixtures thereof;
when a doping agent comprising element Sn is used for preparing Sn-doped N-type indium phosphide single crystal, the doping agent comprising element Sn is selected from the group consisting of tin, a phosphide of tin, an alloy of tin and indium, or mixtures thereof; and
when a doping agent comprising element Zn is used for preparing Zn-doped P-type indium phosphide single crystal, the doping agent comprising element Zn is selected from the group consisting of zinc, a phosphide of zinc, an alloy of zinc and indium, or mixtures thereof.

Embodiment 15. The method according to Embodiment 14, wherein the incorporating agent comprising an incorporation element is selected from the group consisting of a simple substance of the element, a sulfide of the element, a phosphide of the element, an alloy of the element with indium, or a mixture thereof.

Embodiment 16. The method according to Embodiment 14, wherein said incorporation element is iron, and the incorporating agent comprising iron element is selected from the group consisting of iron, iron sulfide ($Fe_2S_3$), ferrous sulfide (FeS), ferrous disulfide ($FeS_2$), a phosphide of iron, iron indium alloy, or any mixture thereof.

Embodiment 17. The method according to any one of Embodiments 8 to 16, wherein the total mass of the doping element in the doping agent comprising the doping element and the incorporation element in the incorporating agent comprising said incorporation element is from 0.001% to 1% (10 ppm to 10000 ppm), relative to the total weight of the indium phosphide polycrystal.

Embodiment 18. The method according to Embodiment 17, wherein the mass ratio of the element S in the doping agent to the incorporation element in the incorporating agent in the solid state is from 1 : 0.1 to 1 : 10, preferably from 1 : 0.5 to 1 : 6, more preferably from 1 : 0.7 to 1 : 5.

Embodiment 19. The method according to any one of Embodiments 8 to 18, wherein the method is selected from a vertical Bridgman method (VB), a vertical gradient freeze method (VGF), a vapor-pressure-controlled Czochralski method (VCZ), or a vertical crucible growth method.

Embodiment 20. Use of an incorporation element for improving a yield of single crystal of an indium phosphide crystal, wherein the indium phosphide crystal is an S-doped or Sn-doped N-type indium phosphide single crystal or a Zn-doped P-type indium phosphide single crystal; and wherein the incorporation element is one or more elements having a segregation coefficient in indium phosphide of not greater than 0.05, preferably not greater than 0.01, more preferably not greater than 0.008.

Embodiment 21. The use according to Embodiment 20, wherein a melt comprising the incorporation element has a viscosity different from that of the melt not comprising the incorporation element, and the incorporation element does not affect the main properties of the crystal and epitaxial use of single crystal wafer.

Embodiment 22. The use according to Embodiment 20 or 21, wherein the incorporation element comprises iron, more preferably is element iron.

Embodiment 23. An indium phosphide single crystal wafer prepared from the indium phosphide single crystal according to any one of Embodiments 1 to 7, or prepared from the indium phosphide single crystal obtained by the method according to any one of Embodiments 7 to 18.

Embodiment 24. The indium phosphide single crystal wafer according to Embodiment 23, wherein the indium phosphide single crystal wafer is used for epitaxial growth thereon or further fabrication into devices comprising optoelectronic devices such as lasers, detectors, light emitting diodes, etc., or electronic devices such as HBT, MESFET, PHEMT, etc.

Embodiment 25. An indium phosphide single crystal wafer, being an S-doped or Sn-doped N-type indium phosphide single crystal wafer or a Zn-doped P-type indium phosphide single crystal wafer; and

the indium phosphide single crystal wafer further comprises an incorporation element, wherein the incorporation element is one or more elements having a segregation coefficient in indium phosphide of not greater than 0.05, preferably not greater than 0.01, more preferably not greater than 0.008; the incorporation element in the indium phosphide crystal is present in an amount of 30 ppb to 30 ppm.

Embodiment 26. The indium phosphide single crystal wafer according to Embodiment 25, wherein the incorporation element comprises iron, more preferably is element iron.

Embodiment 27. The indium phosphide single crystal wafer according to Embodiment 25 or 26, wherein the amount of the incorporation element is from 30 ppb to 20 ppm, preferably from 100 ppb to 15 ppm, more preferably from 150 ppb to 10 ppm.

Embodiment 28. The indium phosphide single crystal wafer according to Embodiment 25 or 26 or 27, wherein the S-doped or Sn-doped N-type indium phosphide single crystal has a carrier concentration of $1\times10^{17}$ cm$^{-3}$ to $5\times10^{19}$ cm$^{-3}$, for example, $1\times10^{18}$ cm$^{-3}$ to $1\times10^{19}$ cm$^{-3}$, preferably $1\times10^{18}$ cm$^{-3}$ to $8\times10^{18}$ cm$^{-3}$, or $1\times10^{17}$ cm$^{-3}$ to $9\times10^{17}$ cm$^{-3}$, preferably $3\times10^{17}$ cm$^{-3}$ to $5\times10^{17}$ cm$^{-3}$; the Zn-doped P-type indium phosphide single crystal wafer has a carrier concentration of $1\times10^{17}$ cm$^{-3}$ to $5\times10^{19}$ cm$^{-3}$, preferably $1\times10^{18}$ cm$^{-3}$ to $1\times10^{19}$ cm$^{-3}$.

Embodiment 29. An electronic device or optoelectronic device, prepared from the indium phosphide single crystal wafer according to any one of Embodiments 23 to 28 or comprising a component prepared from the indium phosphide single crystal wafer according to any one of Embodiments 23 to 28.

Embodiment 30. The optoelectronic device according to Embodiment 29, being a laser, a detector, or a light emitting diode, or the like.

Embodiment 31. The electronic device according to Embodiment 29, being an HBT, a MESFET, or a PHEMT, or the like.

The indium phosphide single crystal containing an incorporation element such as iron obtained in the present application has low density of twin defects and high yield, and can greatly reduce the cost, so that it can be widely applied to optoelectronic devices such as lasers and photodetectors, and high-frequency electronic devices and the like.

## Examples

In order to better understand the present application, the present application will be described in detail below with reference to examples and drawings, but it should be recognized that these examples are merely illustrative of the present application, and are not intended to limit the present application.

Unless otherwise stated, all parts, percentages, and ratios reported in the following examples are based on weight, and all reagents used in the examples are commercially available or synthesized by conventional methods, and can be directly obtained without further treatment, and the instruments used in the examples are commercially available.

Production Equipment

FIG. 1 is a cross-sectional view of an embodiment of a crystal growth apparatus containing a sealed vessel for the growth of sulfur-doped and iron-incorporated indium phosphide single crystal. The apparatus is provided in the high pressure chamber 1 and may comprise a growth tube 3 located in the furnace, wherein the heater 2 consists of a plurality of temperature zones, each of which is individually controlled by a computer controlled by a control system. The pressure within the high pressure chamber 1 is adjusted to, for example, about 2 MPa to 4 MPa. The temperature of each temperature zone is adjusted to provide the temperature profile and temperature gradient required to control the solidification of the melt; and the temperature profile and temperature gradient in the furnace are adjusted so that the crystallization interface moves upwardly through the melt as desired, for example, to establish a temperature gradient of 0.1 °C/cm to 10 °C/cm in the single crystal rod growth zone and to establish a relatively low temperature gradient at the seed crystal end. The crucible 4 in the growth tube (quartz tube) 3 has a seed crystal tank for holding a seed crystal 7, and a single crystal grows along the top of the seed crystal 7. In one embodiment, the crucible 4 may be a pyrolytic boron nitride structure having a cylindrical crystal growth portion, a seed crystal tank cylinder with a smaller diameter and a conical transition portion. The crystal growth section is open at the top of the crucible 4 with a diameter equal to the diameter of the desired crystal product. In an exemplary embodiment, the seed crystal tank cylinder at the bottom of the crucible 4 may have a closed bottom and a diameter slightly larger than the seed crystal 7. The cylindrical crystal growth portion and the seed crystal tank cylinder may have straight walls, or may be tapered gradually outwardly by about 1-30 degrees to facilitate removal of crystal from the crucible 4.

The crucible 4 is adapted to fit inside the growth tube 3 with a narrow gap therebetween. The growth tube 3 is closed at the bottom of its seed crystal tank region and sealed at the top after filling the crucible and raw material.

Since the growth tube-crucible assembly has a funnel shape, a growth tube support is required to adapt to the funnel shape and keep the growth tube 3 stable and upright inside the furnace. In other embodiments, the growth tube-crucible assembly may be configured in different shapes, and the basic structure of the growth tube support will vary depending on the different shapes.

In the VGF crystal growth method, the crystallization temperature gradient of a fixed heat source is moved via an electrical control way, while the crystal remains stationary.

In order to implement vertical gradient freeze growth, the desired temperature gradient profile must be established within the furnace, and the power of each heating zone of the furnace is individually controlled by a computer that is programmed to heat and cool to meet the requirements for the crystallization temperature and temperature gradient of the furnace. For the production of single crystal rods, for example, the temperature fluctuation of the furnace may need to be controlled to less than $\pm$ 1 °C. During the furnace preparation process, phosphorus and indium phosphide polycrystal raw materials 6 containing a doping agent are loaded into the growth tube 3.

In an embodiment, indium sulfide and/or sulfur is/are used as a doping agent, and iron wire is used as an incorporating agent. A seed crystal with a (100) orientation is loaded into a seed crystal tank of the crucible, followed by feeding. The raw materials (comprising the appropriate amounts of doping agent and incorporating agent) are fed into a crucible, which is then placed into the growth tube 3. The growth tube with the crucible is connected to a vacuum system for evacuation, and subsequently sealed. The sealed growth tube is then loaded into the furnace, as shown in FIG. 1. The furnace is turned on to heat the growth tube and its contents to a temperature above 1050°C, the melting point of indium phosphide. The temperature gradient at the crystallization interface can be adjusted to 0.1-10 °C/cm according to different positions of the single crystal rod. The overall temperature profile is adjusted to give a crystallization rate of 2-5 mm/h.

Sulfur-doped and iron-incorporated indium phosphide single crystal rods grown using the above-described exemplary growth process parameters can be used to cut wafers.

The designed growth procedure can obtain a suitable growth rate and a suitable temperature gradient near the solid-liquid interface from the seed crystal end to the completion of single crystal growth (or all the melt solidifies and grows into a solid single crystal).

Under this growth procedure and the conditions of adding appropriate amounts of doping agent and incorporating agent, the single crystal growth is maintained throughout the entire length of the single crystal rod. For example, sulfur-doped and iron-incorporated indium phosphide single crystal rods with a diameter of 2-6 inches can be grown.

When all the raw materials loaded in the crucible are solidified, the grown single crystal rod is cooled to room temperature under the temperature-controlled conditions.

Performance testing

The appearance quality of the prepared sulfur-doped and iron-incorporated indium phosphide single crystal rods was tested by visual inspection under a fluorescent lamp.

The inspection criteria of the prepared initial wafers of sulfur-doped and iron-incorporated indium phosphide single crystal were as follows: a single crystal wafer is qualified if it is visually inspected to be intact and has no crack on its surface .

The dislocation density of the indium phosphide single crystal was determined by the method described in GB/T20230-2022 "Indium Phosphide Single Crystal".

The amount of element iron is determined by the method specified in the following standard "DB35/T 1146-2011 Impurity Content in Silicon Materials Measured by Glow discharge Mass Spectrometry".

The carrier concentration was measured using a hall instrument.

Preparation of sulfur-doped and iron-incorporated indium phosphide single crystal rods

In the examples below, sulfur-doped and iron-incorporated indium phosphide single crystal rods having a diameter of 4 inches were prepared; however, sulfur-doped and iron-incorporated indium phosphide single crystal rods of other diameter sizes can also be prepared using the method of the present application.

The sulfur-doped and iron-incorporated indium phosphide single crystal rods were prepared according to the following steps.

6 kg of indium phosphide polycrystal and a small amount of 6 N high purity red phosphorus were mixed with S-containing doping agent and iron-containing incorporating agent (based on indium phosphide polycrystal) in the amounts described in Table 1; and the mixture, together with 0.2 kg of boron oxide sealant, was loaded into a crucible provided with seed crystal. The crucible was placed in the growth tube, and the growth tube was sealed under vacuum at a vacuum of less than $10^{-3}$ Pa. The growth tube was placed into a crystal growth furnace, using a multi-temperature zone system for heating. The furnace was heated at a heating rate of 20 °C/min to a temperature of 1100 °C, allowing the raw materials in the crucible to melt, and this temperature was maintained for 4 hours. The melt in the crucible thus obtained was cooled, with the temperature gradient of the melt controlled at 2.5 °C/cm and the cooling rate at 0.4 °C/h. Crystallization occurred when the melt was in contact with the seed crystal, yielding the sulfur-doped and iron-incorporated indium phosphide single crystal rod. After the completion of single crystal growth, the sulfur-doped and iron-incorporated indium phosphide single crystal rod was cooled to room temperature. Once cooled to room temperature, the single crystal rod was removed from the crucible, yield a single crystal rod of InP single crystal having a diameter of 105 mm. In addition, the indium phosphide single crystal rods of Comparative Examples 1 and 2 were prepared using similar methods and parameters, with the only modification that the amounts of raw materials were adjusted.

**Table 1. Production parameters for the preparation of indium phosphide single crystal rods**

| No. | Indium sulfide ($In_2S_3$) (g) | Sulfur (g) | Iron (g) | Iron atom content range in the corresponding single crystal #ppb | Qualification improvement rate of single crystal finished product* |
|---|---|---|---|---|---|
| Example 1 | 1.2 | | 0.1 | 30-1000 | 18.6% |
| Example 2 | - | 0.50 | 0.3 | 50-1000 | 28.0% |
| Example 3 | 1.2 | 0.15 | 0.3 | 55-1100 | 32% |
| Example 4 | 1.2 | 0.15 | 1.5 | 250-3500 | 38% |
| Example 5 | 1.2 | 0.15 | 2.0 | 300-10000 | 38.5% |
| Example 6 | 1.2 | 0.15 | 2.5 | 450-21500 | 32% |
| Example 7 | 1.2 | 0.15 | 3.5 | 300-30500 | 3% |
| Comparative Example 1 | 1.2 | 0.15 | - | <0.5 | - |

(continued)

| No. | Indium sulfide (In$_2$S$_3$) (g) | Sulfur (g) | Iron (g) | Iron atom content range in the corresponding single crystal #ppb | Qualification improvement rate of single crystal finished product* |
|---|---|---|---|---|---|
| Comparative Example 2 | 1.2 | 0.15 | 5 | 650-45000 | Observed significant decrease in crystal formation rate |

* For Examples 1 to 7 of the present application and Comparative Example 2, the qualification improvement ratio of single crystal finished product is based on the qualification rate of single crystal product of Comparative Example 1, and is expressed as the increased ratio relative to the qualification rate of the single crystal product of Comparative Example 1. "Crystal formation rate" refers to the ratio of successfully grown single crystals. "Qualification rate of single crystal finished product" refers to the ratio of single crystals that have been successfully grown and tested to meet the quality requirements.

# Since the prepared single crystals are in the form of single crystal rods, the iron atom content measured at different cross sections along the growth direction of the single crystal rod varies. Here, the minimum and maximum values of iron atom content at different positions in the single crystal-yielding part of a single crystal rod are provided.

According to the results of Examples 1 to 7 and Comparative Example 1 in Table 1, it can be seen that when a small amount of incorporation element Fe (with the segregation coefficient of about 0.0016) is introduced during the preparation of indium phosphide crystal so that the atomic content of Fe in the obtained single crystal rod is between about 30 ppb and 30 ppm (30,000 ppb), the qualification rate of the single crystal finished product is improved.

According to the results of Examples 1 to 7 and Comparative Example 2 in Table 1, it can be seen that when the amount of the incorporation element Fe introduced during the preparation of indium phosphide crystal is too large, resulting in the atomic content of Fe in the prepared single crystal rod greatly exceeding 30 ppm (30,000 ppb), the crystal formation rate of the single crystal is significantly reduced (the qualification rate of the single crystal finished product is naturally also reduced).

Preparation of sulfur-doped and iron-incorporated indium phosphide single crystal wafers

The sulfur-doped and iron-incorporated indium phosphide single crystal rods prepared in the above examples were cut into sulfur-doped and iron-incorporated indium phosphide single crystal wafers according to the following steps.

Cutting: Sulfur-doped and iron-incorporated indium phosphide single crystal rods were cut with a multi-wire cutting machine into initial single crystal wafers of sulfur-doped and iron-incorporated indium phosphide single crystals with a thickness of 300 $\mu$m. FIG. 2 shows a schematic diagram of a single crystal rod fixing device used in the preparation of a single crystal wafer of the present application. Sulfur-doped and iron-incorporated indium phosphide single crystal rod 8 was fixed using a fixing device semi-surrounding graphite 9 to conveniently separate it from the single crystal wafers in a subsequent step. During the cutting process, a semi-surrounding graphite fixture was used to fix the cylindrical sulfur-doped and iron-incorporated indium phosphide single crystal rod. After the cutting was completed, the initial single crystal wafer of sulfur-doped and iron-incorporated indium phosphide single crystal was manually removed, and the operation was performed by the same personnel under identical conditions.

Chamfering: Each circular single crystal wafer was edge-chamfered using a chamfering machine so that its edge cross-section became arc-shaped.

Fixing: One side of the single crystal wafer was placed on a circular ceramic plate (Ra < 0.5 $\mu$m) with a diameter of 5.2 cm and a thickness of 250 $\mu$m, and gentle pressure was applied to ensure no air bubbles between the single crystal wafer and the ceramic plate.

Surface treatment: The ceramic plate carrying the single crystal wafer was placed in an etching solution at 35 °C for 12 seconds, the etching solution having a composition of: 1 mol% NH$_3$, 10 mol% hydrogen peroxide, with the balance being water.

Polishing: The ceramic plate carrying the single crystal wafer was then placed and fixed in the support pad cavity of the polishing machine (in close contact with the ceramic plate). The rough polishing solution shown in Table 3 was first applied to the polishing equipment, and polishing was performed for 60 minutes under the rough polishing conditions shown in Table 2. After cleaning with deionized water (resistivity greater than 17.5 MΩ·cm, measured at 25 °C) and drying, the fine polishing solution shown in Table 3 was then applied to the polishing equipment, and polishing was performed for 6 minutes under the fine polishing conditions shown in Table 3. The ceramic plate carrying the single crystal wafer was then removed and placed on a heating furnace to melt the adhesive. The single crystal wafer was detached from the ceramic plate, cleaned with deionized water, and dried.

Cleaning: a) At 10 °C, the single crystal wafer was immersed for 5 minutes in an aqueous solution containing 0.3 wt% $NH_3$ and 1.3% by weight (unless otherwise indicated, all solutions below were given in weight percent based on the total weight of the solution) of hydrogen peroxide. b) At 10 °C, the surface of the single crystal wafer was rinsed with deionized water for 3 minutes. c) At 20 °C, the single crystal wafer was immersed for 5 minutes in a 10% by weight hydrogen peroxide solution. d) At 15 °C, the surface of the single crystal wafer was rinsed with deionized water for 3 minutes; e) At 20 °C, the single crystal wafer was immersed for 5 minutes in a 10 wt% ammonia solution. f) At 15 °C, the surface of the single crystal wafer was rinsed with deionized water for 3 minutes. g) The single crystal wafer was placed in a wafer rotary dryer and dried with hot nitrogen.

The indium phosphide single crystal wafer of Comparative Example 1 was also cut from the indium phosphide single crystal rod prepared in Comparative Example 1 in the same manner as described above. (Due to the low crystal formation rate of the single crystal rod in Comparative Example 2, no single crystal wafer cutting and testing were performed).

The thickness of the obtained indium phosphide single crystal wafer was 250 $\mu$m, and the performance test results of the obtained indium phosphide single crystal wafers of Examples and Comparative Examples were shown in Table 4 below. The carrier concentration was measured by hall meter. The measurement method for the radial distribution of carrier concentrations was as follows: measuring the carrier concentrations at the center of the single crystal wafer and at any point inside the center of the single crystal wafer 3 mm away from the outer periphery of the single crystal wafer; and calculating the deviation from the average value of the two, and taking this as the radial distribution of the carrier concentrations in the indium phosphide single crystal wafer.

**Table 2. Composition of coarse polishing solution and polishing conditions**

| Chemical composition (wt.%, calculated based on total weight of chemicals) | Sodium dichloroisocyanurate | | 15.89 |
|---|---|---|---|
| | Sodium pyrophosphate | | 13.38 |
| | Sodium bicarbonate | | 9.07 |
| | Sodium benzenesulfonate | | 0.14 |
| | Sulfur sol | | 64.06 |
| | Total chemical concentration | | 2.60 |
| Balance (wt.%) | Water | | 97.40 |
| Polishing conditions | Pressure per unit area of crystal wafer, g/cm$^2$ | | 63.75 |
| | Flow rate of polishing fluid, l/cm$^2$ wafer/h | | 83.75 |
| | Rotational speed (rpm) | Upper plate | 22.50 |
| | | Lower plate | 11.00 |

**Table 3. Composition of fine polishing solution and polishing conditions**

| Chemical composition (wt.%, calculated based on total weight of chemicals) | Sodium dichloroisocyanurate | | 33.95 |
|---|---|---|---|
| | Sodium acid pyrophosphate | | 26.65 |
| | Sodium carbonate | | 19.33 |
| | Sodium bicarbonate | | 20.25 |
| | Sodium benzenesulfonate | | 0.36 |
| | Total chemical concentration | | 1.23 |
| Balance (wt.%) | Water | | 98.77 |
| Polishing conditions | Pressure per unit area of crystal wafer (g/cm$^2$) | | 58.75 |
| | Flow rate of polishing fluid (ml/cm$^2$ wafer/min) | | 0.55 |
| | Rotational speed (rpm) | Upper plate | 37.50 |
| | | Lower plate | 22 |

**Table 4. Performance test results of indium phosphide single crystal wafers**

| No. | Average carrier concentration (cm$^{-3}$) | Radial distribution of carrier concentration (%) | Iron atom content# ppb | Dislocation density (cm$^{-2}$) |
|---|---|---|---|---|
| Example 1 | 1.0E+18 | ±10 | 30-200 | 80 |
| Example 2 | 1.2E+18 | ±10 | 50-250 | 50 |
| Example 3 | 2.2E+18 | ±10 | 50-250 | 50 |
| Example 4 | 2.5E+18 | ±10 | 100-350 | 60 |
| Example 5 | 3.5E+18 | ±10 | 200-600 | 50 |
| Example 6 | 5.8E+18 | ±10 | 500-1200 | 50 |
| Example 7 | 8.6E+18 | ±10 | 1000-4000 | 90 |
| Comparative Example 1 | 2.0E+18 | ±10 | <0.5 | 100 |

# In the experiment, it was found that the distribution of Fe atoms in indium phosphide single crystal wafer was also uneven, and the measured iron atom content varied at different positions. Here, the minimum and maximum values of iron atom content at different positions in the single crystal wafer are provided.

From the experimental results in Table 4, it can be seen that although Fe is additionally incorporated, the carrier concentration of the single wafer obtained in each example still meets the requirements of N-type indium phosphide single crystal. Moreover, the carrier concentration is basically uniformly distributed in the radial direction, which meets the industrial preparation requirements of photonic devices or optoelectronic devices.

It should be noted that any indium phosphide crystal substrate (e.g., single crystal rods, wafers, etc.) prepared by the methods/processes disclosed herein is explicitly within the scope of the present application.

Although the foregoing has been described with reference to specific embodiments of the present application, it will be understood by those skilled in the art that modifications or changes may be made to the embodiments without departing from the principles and spirit of the present application, the scope of which is defined by the appended claims.

**Claims**

1.    An indium phosphide crystal, wherein the indium phosphide crystal is an S-doped or Sn-doped N-type indium phosphide single crystal or a Zn-doped P-type indium phosphide single crystal; and
the indium phosphide crystal further comprises an incorporation element, wherein the incorporation element is one or more elements having a segregation coefficient in indium phosphide of not greater than 0.05, preferably not greater than 0.01, more preferably not greater than 0.008; the incorporation element in the indium phosphide crystal is present in an amount of 30 ppb to 30 ppm.

2.    The indium phosphide crystal according to claim 1, wherein the amount of the incorporation element is from 30 ppb to 20 ppm, preferably from 100 ppb to 15 ppm, more preferably from 150 ppb to 10 ppm.

3.    The indium phosphide crystal according to claim 1 or 2, wherein the incorporation element comprises iron.

4.    The indium phosphide crystal according to any one of claims 1 to 3, wherein the incorporation element is element iron.

5.    The indium phosphide crystal according to any one of claims 1 to 4, wherein the indium phosphide crystal is an S-doped or Sn-doped N-type indium phosphide single crystal, and the carrier concentration of the N-type indium phosphide single crystal is $1\times10^{17}$ cm$^3$ to $5\times10^{19}$ cm$^{-3}$, for example, $1\times10^{18}$ cm$^{-3}$ to $1\times10^{19}$ cm$^{-3}$, preferably $1\times10^{18}$ cm$^{-3}$ to $8\times10^{18}$ cm$^{-3}$, or $1\times10^{17}$ cm$^{-3}$ to $9\times10^{17}$ cm$^{-3}$, preferably $3\times10^{17}$ cm$^{-3}$ to $5\times10^{17}$ cm$^{-3}$.

6.    The indium phosphide crystal according to any one of claims 1 to 4, wherein the indium phosphide crystal is a Zn-doped P-type indium phosphide single crystal, and the P-type indium phosphide single crystal has a carrier concentration of $1\times10^{17}$ cm$^{-3}$ to $5\times10^{19}$ cm$^{-3}$, preferably $1\times10^{18}$ cm$^{-3}$ to $1\times10^{19}$ cm$^{-3}$.

7.    The indium phosphide crystal according to any one of claims 1 to 6, wherein the indium phosphide crystal is in the form of an indium phosphide single crystal rod or a single crystal wafer.

8.   A preparation method of an N-type or P-type indium phosphide single crystal, the method comprising a step of placing phosphorus, indium phosphide polycrystal, an incorporating agent comprising an incorporation element, and a doping agent comprising an element S or an element Sn or an element Zn, together with a sealant, into a growth vessel (such as a crucible) provided with a seed crystal; wherein the incorporation element has a segregation coefficient in indium phosphide of not greater than 0.05, preferably not greater than 0.01 preferably not greater than 0.008.

9.   The method according to claim 8, further comprising:

a step of placing said vessel in a crystal growth furnace and heating to a temperature of the melting point of indium phosphide or higher; and
a step of stepwise cooling the melt in the vessel to obtain the N-type or P-type indium phosphide single crystal.

10.   The method according to claim 9, wherein the step of placing said vessel in a crystal growth furnace and heating to a temperature of the melting point of indium phosphide or higher comprises: placing said vessel in a crystal growth furnace and heating using a multi-temperature zone system, preferably establishing a temperature gradient of 0.1-10.0 °C/cm in the single crystal rod growth zone, so that the temperature is increased and maintained at the melting point of indium phosphide or higher.

11.   The method according to any one of claims 8 to 10, wherein the incorporation element comprises iron, preferably is element iron.

12.   The method according to any one of claims 8 to 11, wherein the incorporation element in the obtained indium phosphide crystal is present in an amount of 30 ppb to 30 ppm.

13.   The method according to any one of claims 8 to 12, wherein a melt comprising the incorporation element has a viscosity different from that of the melt not comprising the incorporation element, and the incorporation element does not affect the main properties of the crystal and epitaxial use of single crystal wafer.

14.   The method according to any one of claims 8 to 13, wherein

when a doping agent comprising element S is used for preparing S-doped N-type indium phosphide single crystal, the doping agent comprising element S is selected from the group consisting of sulfur, sulfides of indium, or mixtures thereof;
when a doping agent comprising element Sn is used for preparing Sn-doped N-type indium phosphide single crystal, the doping agent comprising element Sn is selected from the group consisting of tin, a phosphide of tin, an alloy of tin and indium, or mixtures thereof; and
when a doping agent comprising element Zn is used for preparing Zn-doped P-type indium phosphide single crystal, the doping agent comprising element Zn is selected from the group consisting of zinc, a phosphide of zinc, an alloy of zinc and indium, or mixtures thereof.

15.   The method according to claim 14, wherein the incorporating agent comprising an incorporation element is selected from the group consisting of a simple substance of the element, a sulfide of the element, a phosphide of the element, an alloy of the element with indium, or a mixture thereof.

16.   The method according to claim 14, wherein said incorporation element is iron, and the incorporating agent comprising iron element is selected from the group consisting of iron, iron sulfide ($Fe_2S_3$), ferrous sulfide (FeS), ferrous disulfide ($FeS_2$), a phosphide of iron, iron indium alloy, or any mixture thereof.

17.   The method according to any one of claims 8 to 16, wherein the total mass of the doping element in the doping agent comprising the doping element and the incorporation element in the incorporating agent comprising said incorporation element is from 0.001% to 1% (10 ppm to 10000 ppm), relative to the total weight of the indium phosphide polycrystal.

18.   The method according to claim 17, wherein the mass ratio of the element S in the doping agent to the incorporation element in the incorporating agent in the solid state is from 1 : 0.1 to 1 : 10, preferably from 1 : 0.5 to 1 : 6, more preferably from 1 : 0.7 to 1 : 5.

19. The method according to any one of claims 8 to 18, wherein the method is selected from a vertical Bridgman method (VB), a vertical gradient freeze method (VGF), a vapor-pressure-controlled Czochralski method (VCZ), or a vertical crucible growth method.

20. Use of an incorporation element for improving a yield of single crystal of an indium phosphide crystal, wherein the indium phosphide crystal is an S-doped or Sn-doped N-type indium phosphide single crystal or a Zn-doped P-type indium phosphide single crystal; and wherein the incorporation element is one or more elements having a segregation coefficient in indium phosphide of not greater than 0.05, preferably not greater than 0.01, more preferably not greater than 0.008.

21. The use according to claim 20, wherein a melt comprising the incorporation element has a viscosity different from that of the melt not comprising the incorporation element, and the incorporation element does not affect the main properties of the crystal and epitaxial use of single crystal wafer.

22. The use according to claim 20 or 21, wherein the incorporation element comprises iron, preferably is element iron.

23. An electronic device or optoelectronic device, prepared from the indium phosphide crystal according to any one of claims 1 to 7 or comprising a component prepared from the indium phosphide crystal according to any one of claims 1 to 7.

24. The optoelectronic device according to claim 23, being selected from a laser, a detector, or a light emitting diode.

25. The electronic device according to claim 23, being selected from HBT, MESFET, or PHEMT.

FIG. 1

FIG. 2

## INTERNATIONAL SEARCH REPORT

| | International application No. |
|---|---|
| | **PCT/CN2024/108380** |

| **A.** | **CLASSIFICATION OF SUBJECT MATTER** |
|---|---|
| | C30B29/40(2006.01)i;  C30B29/60(2006.01)i |

According to International Patent Classification (IPC) or to both national classification and IPC

| **B.** | **FIELDS SEARCHED** |
|---|---|

Minimum documentation searched (classification system followed by classification symbols)

    IPC:C30B

Documentation searched other than minimum documentation to the extent that such documents are included in the fields searched

Electronic data base consulted during the international search (name of data base and, where practicable, search terms used)

    DWPI, CJFD, CNTXT, ENTXTC, WPABSC: 共掺杂, 磷化铟, 硫, 锡, 铁, 锌掺杂, 成品率, 垂直布里奇曼, 梯度冷凝, 坩埚生长, dope, doping, codope, InP, Sn, S, Fe, Zn, VB, VGF, VCZ, Vertical bridgman, vertical gradient freeze

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| X | CN 111952150 A (SUMITOMO ELECTRIC INDUSTRIES, LTD.) 17 November 2020 (2020-11-17)<br>    description, paragraphs [0065] and [0088] | 1-2, 5-7, 23-25 |
| Y | CN 111952150 A (SUMITOMO ELECTRIC INDUSTRIES, LTD.) 17 November 2020 (2020-11-17)<br>    description, paragraphs [0065] and [0088] | 8-10, 13-19 |
| A | CN 111952150 A (SUMITOMO ELECTRIC INDUSTRIES, LTD.) 17 November 2020 (2020-11-17)<br>    description, paragraphs [0065] and [0088] | 3-4, 11-12, 20-22 |
| Y | CN 116043318 A (BEIJING TONGMEI CRYSTAL TECHNOLOGY CO., LTD.) 02 May 2023 (2023-05-02)<br>    description, paragraphs [0007]-[0010] and [0041] | 8-10, 13-19 |
| A | GB 2097583 A (UK SECRETARY OF STATE FOR DEFENCE) 03 November 1982 (1982-11-03)<br>    entire document | 1-25 |

☑ Further documents are listed in the continuation of Box C.      ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **29 September 2024** | **15 October 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2024/108380**

| C. | DOCUMENTS CONSIDERED TO BE RELEVANT | |
|---|---|---|
| Category* | Citation of document, with indication, where appropriate, of the relevant passages | Relevant to claim No. |
| A | JP 2011026176 A (SUMITOMO ELECTRIC INDUSTRIES, LTD.) 10 February 2011 (2011-02-10)<br>entire document | 1-25 |
| A | CN 107675262 A (BEIJING DINGTAI XINYUAN TECHNOLOGY DEVELOPMENT CO., LTD.) 09 February 2018 (2018-02-09)<br>entire document | 1-25 |

Form PCT/ISA/210 (second sheet) (July 2022)

## INTERNATIONAL SEARCH REPORT
### Information on patent family members

| International application No. |
| --- |
| **PCT/CN2024/108380** |

| Patent document cited in search report | | | Publication date (day/month/year) | Patent family member(s) | | | Publication date (day/month/year) |
| --- | --- | --- | --- | --- | --- | --- | --- |
| CN | 111952150 | A | 17 November 2020 | US | 2017363406 | A1 | 21 December 2017 |
| | | | | US | 10473445 | B2 | 12 November 2019 |
| | | | | TW | 201937541 | A | 16 September 2019 |
| | | | | TWI | 701709 | B | 11 August 2020 |
| | | | | EP | 3258481 | A1 | 20 December 2017 |
| | | | | EP | 3258481 | A4 | 19 September 2018 |
| | | | | JPWO | 2016129172 | A1 | 27 April 2017 |
| | | | | JP | 6296177 | B2 | 20 March 2018 |
| | | | | TW | 201638995 | A | 01 November 2016 |
| | | | | TWI | 667687 | B | 01 August 2019 |
| | | | | WO | 2016129172 | A1 | 18 August 2016 |
| | | | | JP | 2018133571 | A | 23 August 2018 |
| | | | | JP | 6508373 | B2 | 08 May 2019 |
| | | | | US | 2020041247 | A1 | 06 February 2020 |
| | | | | US | 10663277 | B2 | 26 May 2020 |
| | | | | EP | 4174913 | A1 | 03 May 2023 |
| | | | | JP | 2019145812 | A | 29 August 2019 |
| | | | | CN | 107112201 | B | 28 July 2020 |
| | | | | CN | 111952150 | B | 20 June 2023 |
| | | | | CN | 107112201 | A | 29 August 2017 |
| CN | 116043318 | A | 02 May 2023 | None | | | |
| GB | 2097583 | A | 03 November 1982 | GB | 2097583 | B | 27 February 1985 |
| JP | 2011026176 | A | 10 February 2011 | None | | | |
| CN | 107675262 | A | 09 February 2018 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311238715
- GB 202302022 T
- CN 116043318 A

**Non-patent literature cited in the description**

- **FANG DUNFU et al.** The Growth and Characterics of S-doped Low Dislocation InP Single Crystals. *Journal of Applied Sciences*, July 1983, vol. 1 (3)